# EUROPEAN PATENT SPECIFICATION

(11) **EP 4 080 581 B1**
(45) Date of publication and mention of the grant of the patent: **26.02.2025**
(21) Application number: 20913841.1
(22) Date of filing: 15.07.2020
(51) Int. Cl.: H01L 29/778, H01L 29/10, H01L 27/02, H01L 21/337, H01L 29/417, H01L 29/861, H01L 29/20, H01L 29/06

(54) **NITRIDE SEMICONDUCTOR TRANSISTOR AND ELECTRONIC DEVICE**
NITRIDHALBLEITERTRANSISTOR UND ELEKTRONISCHE VORRICHTUNG
TRANSISTOR SEMI-CONDUCTEUR AU NITRURE ET DISPOSITIF ÉLECTRONIQUE

(30) Priority: 16.01.2020 CN 202020096822 U
(43) Date of publication of application: 26.10.2022
(73) Proprietor: Huawei Technologies Co., Ltd., Shenzhen, Guangdong 518129, (CN)
(72) Inventor: JIANG, Qimeng, Shenzhen, Guangdong 518129 (CN); CHEN, Zhibin, Shenzhen, Guangdong 518129 (CN)
(74) Representative: Maiwald GmbH
(86) International application number: PCT/CN2020/102217
(87) International publication number: WO 2021/143080

(56) References cited:
- CN-A- 104 134 690
- CN-A- 104 659 082
- CN-A- 110 137 244
- CN-A- 110 379 807
- FR-A1- 3 059 467
- JP-B2- 6 011 414
- US-A1- 2007 045 765
- US-A1- 2011 260 174
- US-A1- 2012 153 355

## Description

### TECHNICAL FIELD

This application relates to the field of semiconductor power device technologies, and in particular, to a nitride semiconductor transistor and an electronic device.

### BACKGROUND

Gallium nitride (gallium nitride, GaN) has advantages of a large width of forbidden band and high mobility, and is widely used in a power electronic device and a radio frequency device, especially in a high electron mobility transistor (high electron mobility transistor, HEMT). The HEMT has a heterostructure that can generate two-dimensional electron gas and also has features of high mobility and high breakdown field strength, and therefore becomes an ideal substitute for a next-generation power electronic device and radio frequency device.

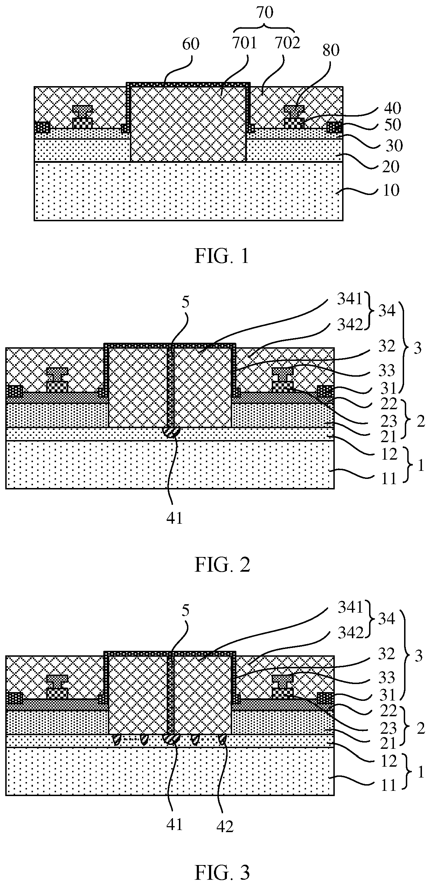

In a structural design of the HEMT, a breakdown voltage is an important design parameter, which basically determines maximum output power of a power device. Specifically, in a structure of a HEMT as shown in FIG. 1, the HEMT has a substrate 1, and a GaN buffer layer 20, a barrier layer 30, and a P-type GaN layer 40 that are epitaxially formed on the substrate 10, to ensure a longitudinal breakdown voltage of the GaN buffer layer 20. Certainly, the HEMT further includes a source 50, a drain 60, an isolation layer 70 that are disposed on the barrier layer 30, and a gate 80 disposed on the P-type GaN layer 40. The drain 60 separates the isolation layer 70 into a first isolation portion 701 and a second isolation portion 702, and the first isolation portion 701 is in contact with the substrate 10 after extending towards a side of the substrate 10 to penetrate through the barrier layer 30 and the nitride buffer layer 20. During operation of the HEMT, if a source-drain voltage is larger than a breakdown voltage, the transistor is prone to be broken down, and consequently the transistor permanently fails. Therefore, gate-drain spacing is usually increased to nearly double a withstanding voltage, to prevent the transistor from being broken down. However, the increase in the gate-drain spacing undoubtedly enlarges an area occupied by a single device, which causes manufacturing costs to increase.

Document US 2011/260174 A1 describes structures and methods for power devices with integrated clamp structures. The integration of clamp structures can protect the power device, e.g., from electrical overstress (EOS).

Document US 2012/153355 A1 describes a nitride semiconductor device including a semiconductor substrate, and a nitride semiconductor layer formed on the semiconductor substrate. The semiconductor substrate includes a normal region and an interface current block region surrounding the normal region. The interface current block region contains impurities, and forms a potential barrier against carriers generated at an interface between the nitride semiconductor layer and the semiconductor substrate.

### SUMMARY

This application provides a nitride semiconductor transistor and an electronic device, to provide a current discharge channel when a transistor is broken down, thereby improving security and reliability of a power device. The present invention is defined in the independent claim and the dependent claims define the advantages embodiments thereof.

According to a first aspect, this application provides a nitride semiconductor transistor. The nitride semiconductor transistor may be applied to an electronic device, and provides higher security assurance for the electronic device during operation. Specifically, a structure of the nitride semiconductor transistor includes a substrate structure, a nitride epitaxial structure, and a functional electrode layer that are successively disposed from bottom to up. The substrate structure includes a two-layer structure including a heavily doped P-type substrate and a lightly doped P-type epitaxial layer, and a side that is of the lightly doped P-type epitaxial layer and that is away from the heavily doped P-type substrate extends towards the heavily doped P-type substrate to form an N-type region, which is equivalent to forming a PN-type diode at the bottom of the entire transistor. Because doping concentration of P-type ions in the heavily doped P-type substrate is greater than doping concentration of P-type ions in the lightly doped P-type epitaxial layer, the heavily doped P-type substrate and the lightly doped P-type epitaxial layer enable a current to present unidirectional conductivity of being conducted in one direction from the heavily doped P-type substrate to the lightly doped P-type epitaxial layer, to prevent the current from being conducted to the heavily doped P-type substrate, thereby improving voltage withstanding of the transistor. The nitride epitaxial structure includes a nitride buffer layer, a barrier layer, and a P-type nitride layer that are successively formed on the lightly doped P-type epitaxial layer. The barrier layer is disposed on the nitride buffer layer in a fully covered form, and the P-type nitride layer is disposed only at a specified location on the barrier layer. The functional electrode layer includes a source, a drain, a gate, and an isolation layer. The gate is disposed on the P-type nitride layer, and the source and the drain are disposed on the barrier layers on both sides of the P-type nitride layer. The drain separates the isolation layer into a first isolation portion and a second isolation portion. The first isolation portion herein corresponds to the N-type region to penetrate through the barrier layer and the nitride buffer layer to be in contact with the lightly doped P-type epitaxial layer. A metal connector is formed in the first isolation portion, and the metal connector penetrates through the first isolation portion to connect the drain and the N-type region. During operation, if a source-drain voltage is relatively large, the N-type region is connected to the drain through the metal connector, which is equivalent to providing a discharge channel for a current, to ensure that the transistor is not broken down. Even if a surge phenomenon occurs in use of the transistor, a device is protected from being damaged, to improve device reliability. In addition, gate-drain spacing is not increased in this structure, so that a design redundancy value of a breakdown voltage can be reduced, device density can be improved, and production costs can be decreased.

Based on the foregoing structure, a protection ring combination surrounding the N-type region is further formed on the lightly doped P-type epitaxial layer, to improve an inverse characteristic of the PN-type diode formed by using the heavily doped P-type substrate, the lightly doped P-type epitaxial layer, and the N-type region, thereby enhancing device reliability. Certainly, the protection ring combination specifically includes at least one protection ring using the N-type region as a center, and a quantity of protection rings is not limited.

The heavily doped P-type substrate and the lightly doped P-type epitaxial layer form the substrate structure of the transistor. The lightly doped P-type epitaxial layer may improve controllability and uniformity of a near-surface silicon layer. In a specific implementation, a substrate in the heavily doped P-type substrate may be made of any material in silicon (silicon, Si), silicon carbide (silicon carbide, SiC), silicon nitride (Silicon nitride, SiN), GaN, and sapphire. Certainly, a material of a substrate in the lightly doped P-type epitaxial layer may also be made of any material in Si, SiC, SiN, GaN, and sapphire. In addition, resistivity of the heavily doped P-type substrate is set to be less than 10 Ω/mm, and resistivity of the lightly doped P-type epitaxial layer is set to 10 Ω/mm to 1000 Ω/mm. Herein, a thickness of the lightly doped P-type epitaxial layer usually ranges from 5 µm to 20 µm, and a thickness of the heavily doped P-type substrate is not limited. The thickness of the heavily doped P-type substrate may be adjusted based on a thickness of the entire substrate.

Nitride in the nitride epitaxial structure may be one or a combination of several of GaN, aluminum nitride (aluminum nitride, AlN), indium nitride (indium nitride, InN), aluminum gallium nitride (aluminum gallium nitride, AlGaN), indium aluminum nitride (indium aluminum nitride, InAlN), indium gallium nitride (indium gallium nitride, InGaN), and indium aluminum gallium nitride (indium aluminum gallium nitride, InAlGaN). In addition, a material of the metal connector may be tungsten.

According to a second aspect, this application further provides an electronic device, including a device body and any nitride semiconductor transistor that is according to the foregoing technical solutions and that is disposed on the device body. Based on that the nitride semiconductor transistor has higher security and reliability, a service life of the electronic device may be prolonged.

### BRIEF DESCRIPTION OF DRAWINGS

FIG. 1 is a schematic diagram of a structure of a HEMT in the conventional technology;
FIG. 2 is a schematic diagram of a structure of a nitride semiconductor transistor according to one example not covered by the claims;
FIG. 3 is a schematic diagram of a structure of another nitride semiconductor transistor according to this embodiment;
FIG. 4 is a top view of a substrate structure in another nitride semiconductor transistor according to this embodiment; and
FIG. 5a to FIG. 5i are schematic diagrams of structural changes in a process of manufacturing a nitride semiconductor transistor according to this embodiment.

### DESCRIPTION OF EMBODIMENTS

The following clearly and completely describes the technical solutions in embodiments of this application with reference to the accompanying drawings in embodiments of this application.

First, an application scenario of this application is described: A breakdown voltage is an important parameter in a structural design of a HEMT. If a source-drain voltage is greater than the breakdown voltage during operation of the HEMT, the transistor is broken down, and consequently the transistor permanently fails. Currently, a method for improving this condition is to increase gate-drain spacing. However, in this method, a device occupation area is enlarged, device density is reduced, and device costs are increased.

Based on the foregoing application scenario, this application provides a nitride semiconductor transistor, to avoid an adverse effect on a device volume while the foregoing problem that the source-drain voltage is excessively large to break down the device is resolved.

Referring to FIG. 2, a structure of the nitride semiconductor transistor includes a substrate structure 1, a nitride epitaxial structure 2, and a functional electrode layer 3 that are successively disposed from bottom to up. The substrate structure 1 includes a heavily doped P-type substrate 11 and a lightly doped P-type epitaxial layer 12 that are disposed through stacking. Existence of the lightly doped P-type epitaxial layer 12 may improve controllability and uniformity of a near-surface silicon layer. A side that is of the lightly doped P-type epitaxial layer 12 and that is away from the heavily doped P-type substrate 11 extends towards the heavily doped P-type substrate 11 to form an N-type region 41. In this case, it is equivalent to that the heavily doped P-type substrate 11, the lightly doped P-type epitaxial layer 12, and the N-type region 41 form a PN-type diode. The nitride epitaxial structure 2 is disposed on the lightly doped P-type epitaxial layer 12, and specifically includes a nitride buffer layer 21, a barrier layer 22, and a P-type nitride layer 23 that are disposed through stacking. The barrier layer 22 herein fully covers the nitride buffer layer 21, and the P-type nitride layer 23 is disposed at a specified location on the barrier layer 22, to reserve a part of the barrier layer 22 for disposing another structure. The functional electrode layer 3 includes a source 31, a drain 32, a gate 33, and an isolation layer 34. The gate 33 is disposed on the P-type nitride layer 23, and the source 31 and the drain 32 are disposed on the barrier layers 22 on both sides of the P-type nitride layer 23. In other words, it is equivalent to that the gate 33 is disposed between the source 31 and the drain 32. The isolation layer 34 covers the source 31, the P-type nitride layer 23, and the gate 33, and the drain 32 separates the isolation layer 34 into a first isolation portion 341 and a second isolation portion 342. As shown in FIG. 2, the first isolation portion 341 corresponds to the N-type region 41, and the first isolation portion 341 extends towards the heavily doped P-type substrate 11, and successively penetrates through the barrier layer 22 and the nitride buffer layer 21 to be in contact with the lightly doped P-type epitaxial layer 12. In addition, a metal connector 5 that penetrates through the first isolation portion 341 is formed in the first isolation portion 341 to connect the drain 32 and the N-type region 41, to provide a discharge channel for a current. During operation of the transistor, if a source-drain voltage is relatively large, the foregoing discharge channel provides a channel for the current, so that the transistor can be prevented from being burnt, a surge problem also can be resisted, thereby improving safety and reliability of the transistor. Still referring to the structure of the nitride semiconductor transistor in FIG. 2, it can be learned that compared with that in the conventional technology, gate-drain spacing is not increased in this structure, so that a design redundancy value of a breakdown voltage can be reduced, and device density can be improved, to decrease production costs.

Certainly, doping concentration of P-type ions in the heavily doped P-type substrate 11 is greater than doping concentration of P-type ions in the lightly doped P-type epitaxial layer 12, so that the heavily doped P-type substrate 11 and the lightly doped P-type epitaxial layer 12 present unidirectional conductivity. It can be predicted that a current is conducted in one direction from the heavily doped P-type substrate 11 to the lightly doped P-type epitaxial layer 12, to prevent the current from flowing to the heavily doped P-type substrate 11, thereby improving voltage withstanding of the transistor. Herein, resistivity of the heavily doped P-type substrate 11 may be set to be less than 10 Ω/mm, and correspondingly, resistivity of the lightly doped P-type epitaxial layer 12 may be set to 10 Ω/mm to 1000 Ω/mm.

In addition, a thickness of the lightly doped P-type epitaxial layer 12 usually ranges from 5 µm to 20 µm, and a thickness of the heavily doped P-type substrate 11 is not limited. The thickness of the heavily doped P-type substrate 11 may be adjusted based on a bottom thickness of the entire transistor.

A material of a substrate in the heavily doped P-type substrate 11 may be any one of Si, SiC, GaN, and sapphire. Certainly, a material of a substrate in the lightly doped P-type epitaxial layer 12 may also be any one of Si, SiC, GaN, and sapphire. Nitride in the nitride epitaxial structure 2 may be one or a combination of several of GaN, AlN, InN, AlGaN, InAlN, InGaN, and InAlGaN. A material of the metal connector 5 may be tungsten, and certainly may be other materials with good conductivity (for example copper and copper alloy).

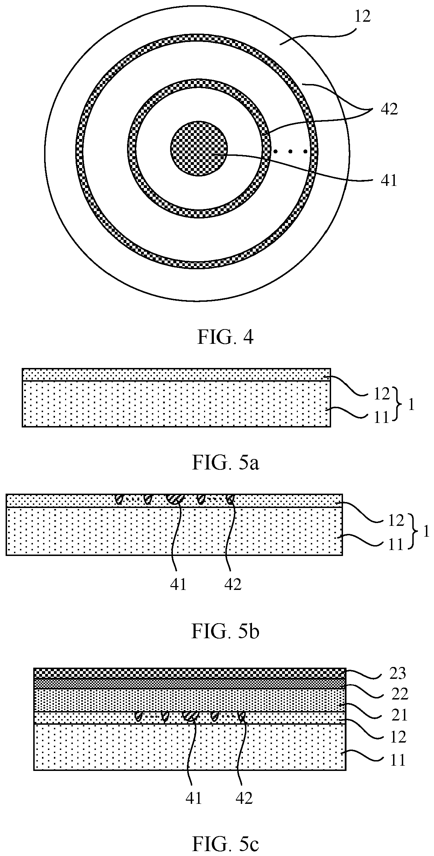

According to the invention, a protection ring combination surrounding the N-type region 41 is formed on the side that is of the lightly doped P-type epitaxial layer 12 and that is away from the heavily doped P-type substrate 11 in the nitride semiconductor transistor shown in FIG. 2, to obtain a nitride semiconductor transistor shown in FIG. 3. The protection ring combination includes at least one protection ring 42, and each protection ring 42 uses the N-type region 41 as a center. FIG. 4 is a top view of the substrate structure 1 of this nitride semiconductor transistor. It may be understood that only a protection ring 42 closest to the N-type region 41 and a protection ring furthest from the N-type region 41 are shown in FIG. 3 and FIG. 4. The protection ring combination may improve an inverse characteristic of the PN-type diode formed by using the heavily doped P-type substrate 11, the lightly doped P-type epitaxial layer 12, and the N-type region 41, thereby enhancing device reliability.

It may be understood that the two nitride semiconductor transistor structures shown in FIG. 2 and FIG. 3 are merely examples, and a partial structure of the nitride semiconductor transistor is shown by using the N-type region 41 as a center. In practical application, the structures shown in FIG. 2 and FIG. 3 exist in a continuous manner.

Taking the nitride semiconductor transistor structure shown in FIG. 3 as an example, for a method for manufacturing the nitride semiconductor transistor, refer to the following steps.

S1: Manufacture a PN junction on a substrate structure 1. The substrate structure 1 herein includes a heavily doped P-type substrate 11 and a lightly doped P-type epitaxial layer 12, where resistivity of the heavily doped P-type substrate 11 is set to be less than 10 Ω/mm, and resistivity of the lightly doped P-type epitaxial layer 12 is set to 10 Ω/mm to 1000 Ω/mm.

Specifically, the lightly doped P-type epitaxial layer 12 of 5 µm to 20 µm is epitaxially formed on the heavily doped P-type substrate 11 through chemical vapor deposition or magnetron sputtering, thereby obtaining a structure shown in FIG. 5a. Then, an alignment mark is etched on the lightly doped P-type epitaxial layer 12 for positioning in a subsequent process, and an N-type impurity such as phosphorus is implanted into the lightly doped P-type epitaxial layer 12 by using an ion to form an N-type region 41 and at least one protection ring 42, thereby obtaining a structure shown in FIG. 5b.

S2: Manufacture a nitride epitaxial structure 2. The nitride epitaxial structure 2 herein refers to a nitride buffer layer 21, a barrier layer 22, and a P-type nitride layer 23 that are successively disposed through stacking on the lightly doped P-type epitaxial layer 12, to implement a functional structure of a HEMT. For a structure of the HEMT, refer to FIG. 5c.

S3: Manufacture a functional electrode layer 3 on the nitride epitaxial structure 2. The functional electrode layer 3 herein may specifically include a source 31, a drain 32, a gate 33, and an isolation layer 34.

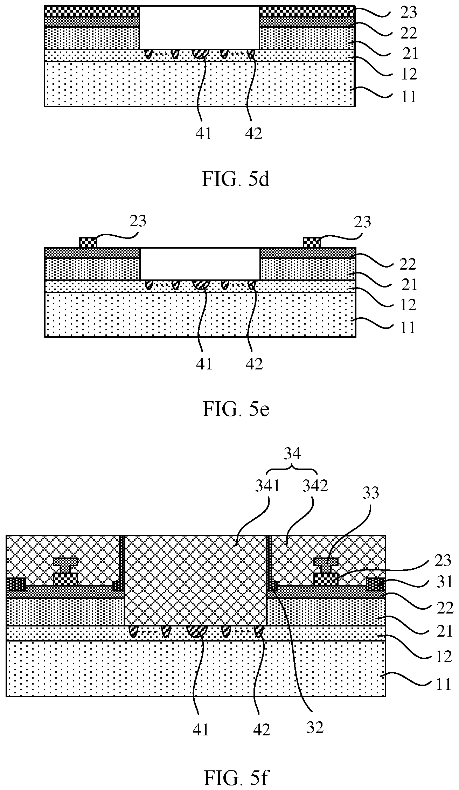

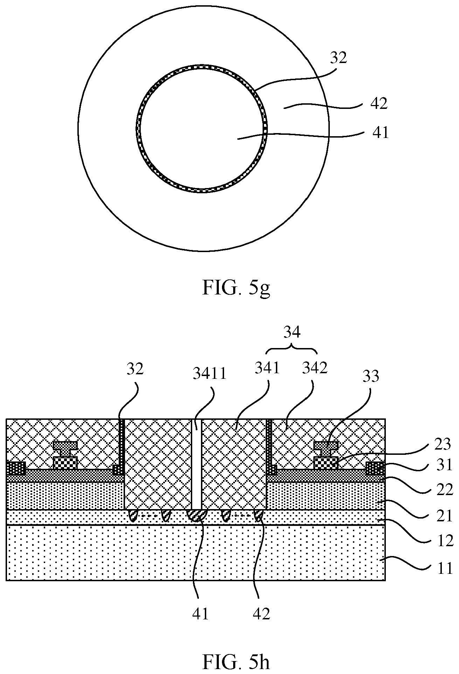

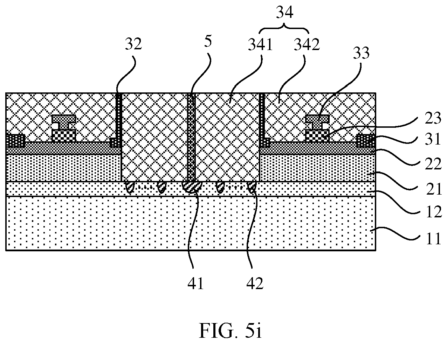

Specifically, corresponding to a region in which the N-type region 41 is located, the P-type nitride layer 23, the barrier layer 22, and the nitride buffer layer 21 are etched to expose the N-type region 41 on the lightly doped P-type epitaxial layer 12, thereby obtaining a structure shown in FIG. 5d. The P-type nitride layer 23 is etched, so that only a part for disposing the gate 33 is left, and the other part of the P-type nitride layer 23 is etched to expose the barrier layer 22, thereby obtaining a structure shown in FIG. 5e. The gate 33 is disposed on the P-type nitride layer 23, the source 31 and the drain 32 are separately disposed on the barrier layers 22 on both sides of the gate 33, and the isolation layer 34 is disposed, so that the drain 32 separates the isolation layer 34 into a first isolation portion 341 and a second isolation portion 342. The first isolation portion 341 corresponds to the N-type region 41, thereby obtaining a structure shown in FIG. 5f. For a top view of the structure shown in FIG. 5f, refer to FIG. 5g. A through hole 3411 extending to the N-type region 41 is formed on the first isolation portion 341, thereby obtaining a structure shown in FIG. 5h. The through hole 3411 is filled with tungsten metal to form a metal connector 5, thereby obtaining a structure as shown in FIG. 5i. The drain 32 is extended to be connected to the metal connector 5, to implement connection between the drain 32 and the N-type region 41, thereby obtaining the nitride semiconductor transistor shown in FIG. 3.

It may be understood that the nitride semiconductor transistor may be applied to different scenarios. For example, the nitride semiconductor transistor may be applied, as a power electronic device, to an electric energy conversion and circuit control aspect of a power device, or may be applied, as a radio frequency device, to a radio frequency signal processing aspect of a wireless transmission system. Details are not described herein. Based on the foregoing embodiment, this application further provides an electronic device having the nitride semiconductor transistor. The nitride semiconductor transistor has a better low cost advantage and reliability, costs of the transistor can be effectively decreased, which is helpful for prolonging a service life of the electronic device, and the electronic device has relatively high safety in a use process.

## Claims

1. A nitride semiconductor transistor, comprising a substrate structure (1), a nitride epitaxial structure (2), and a functional electrode layer (3), wherein
the substrate structure (1) comprises a heavily doped P-type substrate (11) and a lightly doped P-type epitaxial layer (12) that are disposed through stacking, and an N-type region (41) extending from a side that is of the lightly doped P-type epitaxial layer and that is away from the heavily doped P-type substrate towards the heavily doped P-type substrate ;
the nitride epitaxial structure (2) comprises a nitride buffer layer (21), a barrier layer (22), and a P-type nitride layer (23) that are successively formed on the lightly doped P-type epitaxial layer (12);
the functional electrode layer (3) comprises a source (31), a drain (32), a gate (33), and an isolation layer (34), the source and the drain are disposed on the barrier layer (22), the gate is disposed on the P-type nitride layer (23), and the isolation layer covers the source, the gate, the barrier layer, and the P-type nitride layer; and
the drain (32) separates the isolation layer (34) into a first isolation portion (341) and a second isolation portion (342), the first isolation portion penetrates through the barrier layer (22) and the nitride buffer layer (21) to be in contact with the lightly doped P-type epitaxial layer (12) and the N-type region (41), a metal connector (5) is formed in the first isolation portion, and the metal connector penetrates through the first isolation portion to connect the drain and the N-type region,
wherein a protection ring combination surrounding the N-type region (41) is formed on the lightly doped P-type epitaxial layer (12), and
wherein the protection ring combination comprises at least one protection ring (42) and said at least one protection ring is N-type.

2. The nitride semiconductor transistor according to claim 1, wherein a material of the heavily doped P-type substrate is any one of Si, SiC, GaN, or sapphire, and a material of the lightly doped P-type epitaxial layer is any one of Si, SiC, GaN, and sapphire.

3. The nitride semiconductor transistor according to any one of claims 1 to 2, wherein resistivity of the heavily doped P-type substrate is less than 10 Ω/mm.

4. The nitride semiconductor transistor according to any one of claims 1 to 3, wherein resistivity of the lightly doped P-type epitaxial layer is 10 Ω/mm to 1000 Ω/mm.

5. The nitride semiconductor transistor according to any one of claims 1 to 4, wherein nitride in the nitride epitaxial structure is one or a combination of several of GaN, AlN, InN, AlGaN, InAlN, InGaN, and InAlGaN.

6. An electronic device, comprising a device body and the nitride semiconductor transistor that is according to any one of claims 1 to 5 and that is disposed in the device body.

## Patentansprüche

1. Nitridhalbleitertransistor, der eine Substratstruktur (1), eine Nitridepitaxiestruktur (2) und eine funktionelle Elektrodenschicht (3) umfasst, wobei
die Substratstruktur (1) ein stark dotiertes P-Typ-Substrat (11) und eine leicht dotierte P-Typ-Epitaxieschicht (12), die durch ein Stapeln angeordnet sind, und einen N-Typ-Bereich (41), der sich von einer Seite der leicht dotierten P-Typ-Epitaxieschicht und die von dem stark dotierten P-Typ-Substrat weg weist, in Richtung des stark dotierten P-Typ-Substrats erstreckt, umfasst;
die Nitridepitaxiestruktur (2) eine Nitridpufferschicht (21), eine Barriereschicht (22) und eine P-Typ-Nitridschicht (23), die nacheinander auf der leicht dotierten P-Typ-Epitaxieschicht (12) ausgebildet werden, umfasst;
die funktionelle Elektrodenschicht (3) eine Quelle (31), einen Drain (32), ein Gate (33) und eine Isolierschicht (34) umfasst, die Quelle und der Drain auf der Barriereschicht (22) angeordnet sind, das Gate auf der P-Typ-Nitridschicht (23) angeordnet ist und die Isolierschicht die Quelle, das Gate, die Barriereschicht und die P-Typ-Nitridschicht bedeckt; und
der Drain (32) die Isolierschicht (34) in einen ersten Isolierabschnitt (341) und einen zweiten Isolierabschnitt (342) trennt, der erste Isolierabschnitt die Barriereschicht (22) und die Nitridpufferschicht (21) durchdringt, um mit der leicht dotierten P-Typ-Epitaxieschicht (12) und dem N-Typ-Bereich (41) in Kontakt zu stehen, ein Metallverbinder (5) in dem ersten Isolierabschnitt ausgebildet ist und der Metallverbinder den ersten Isolierabschnitt durchdringt, um den Drain und den N-Typ-Bereich zu verbinden,
wobei eine Schutzringkombination, die den N-Typ-Bereich (41) umgibt, auf der leicht dotierten P-Typ-Epitaxieschicht (12) ausgebildet ist, und
wobei die Schutzringkombination mindestens einen Schutzring (42) umfasst und der mindestens eine Schutzring N-Typ ist.

2. Nitridhalbleitertransistor nach Anspruch 1, wobei ein Material des stark dotierten P-Typ-Substrats in beliebiges von Si, SiC, GaN oder Saphir ist und ein Material der leicht dotierten P-Typ-Epitaxieschicht ein beliebiges von Si, SiC, GaN oder Saphir ist.

3. Nitridhalbleitertransistor nach einem der Ansprüche 1 bis 2, wobei ein spezifischer Widerstand des stark dotierten P-Typ-Substrats geringer als 10 Ω/mm ist.

4. Nitridhalbleitertransistor nach einem der Ansprüche 1 bis 3, wobei der spezifische Widerstand der leicht dotierten P-Typ-Epitaxieschicht 10 Ω/mm bis 1000 Ω/mm ist.

5. Nitridhalbleitertransistor nach einem der Ansprüche 1 bis 4, wobei Nitrid in der Nitridepitaxiestruktur eines oder eine Kombination von mehreren von GaN, AIN, InN, AlGaN, InAIN, InGaN und InAIGaN ist.

6. Elektronische Vorrichtung, die einen Vorrichtungskörper und den Nitridhalbleitertransistor nach einem der Ansprüche 1 bis 5 umfasst und der in dem Vorrichungskörper angeordnet ist.

## Revendications

1. Transistor à semi-conducteur au nitrure, comprenant une structure de substrat (1), une structure épitaxiale de nitrure (2), et une couche d'électrode fonctionnelle (3), dans lequel la structure de substrat (1) comprend un substrat de type P fortement dopé (11) et une couche épitaxiale de type P légèrement dopée (12) qui sont disposés par empilement, et une région de type N (41) s'étendant d'un côté, qui fait partie de la couche épitaxiale de type P légèrement dopée et qui est éloigné du substrat de type P fortement dopé, vers le substrat de type P fortement dopé ;
la structure épitaxiale de nitrure (2) comprend une couche tampon de nitrure (21), une couche barrière (22), et une couche de nitrure de type P (23) qui sont formées successivement sur la couche épitaxiale de type P légèrement dopée (12) ;
la couche d'électrode fonctionnelle (3) comprend une source (31), un drain (32), une grille (33), et une couche d'isolation (34), la source et le drain sont disposés sur la couche barrière (22), la grille est disposée sur la couche de nitrure de type P (23), et la couche d'isolation recouvre la source, la grille, la couche barrière, et la couche de nitrure de type P ; et
le drain (32) sépare la couche d'isolation (34) en une première partie d'isolation (341) et une seconde partie d'isolation (342), la première partie d'isolation traverse la couche barrière (22) et la couche tampon de nitrure (21) pour être en contact avec la couche épitaxiale de type P légèrement dopée (12) et la région de type N (41), un connecteur métallique (5) est formé dans la première partie d'isolation, et le connecteur métallique traverse la première partie d'isolation pour relier le drain et la région de type N,
dans lequel une combinaison d'anneaux de protection entourant la région de type N (41) est formée sur la couche épitaxiale de type P légèrement dopée (12), et dans lequel la combinaison d'anneaux de protection comprend au moins un anneau de protection (42) et ledit au moins un anneau de protection est de type N.

2. Transistor à semi-conducteur au nitrure selon la revendication 1, dans lequel un matériau du substrat de type P fortement dopé est l'un quelconque parmi Si, SiC, GaN, ou saphir, et un matériau de la couche épitaxiale de type P légèrement dopée est l'un quelconque parmi Si, SiC, GaN, et saphir.

3. Transistor à semi-conducteur au nitrure selon l'une quelconque des revendications 1 à 2, dans lequel la résistivité du substrat de type P fortement dopé est inférieure à 10 Ω/mm.

4. Transistor à semi-conducteur au nitrure selon l'une quelconque des revendications 1 à 3, dans lequel la résistivité de la couche épitaxiale de type P légèrement dopée est comprise entre 10 Ω/mm et 1 000 Ω/mm.

5. Transistor à semi-conducteur au nitrure selon l'une quelconque des revendications 1 à 4, dans lequel le nitrure dans la structure épitaxiale de nitrure est l'un ou une combinaison de plusieurs parmi GaN, AIN, InN, AIGaN, InAIN, InGaN, et InAIGaN.

6. Dispositif électronique, comprenant un corps de dispositif et le transistor à semi-conducteur au nitrure selon l'une quelconque des revendications 1 à 5 et qui est disposé dans le corps de dispositif.
